# EUROPEAN PATENT APPLICATION

(11) **EP 4 836 295 A1**
(43) Date of publication of application: **04.11.2026**
(21) Application number: 26172687.1
(22) Date of filing: 16.04.2026
(51) Int. Cl.: H03B 5/30, H03B 5/42

(54) **MEMS OSCILLATOR WITH REDUCED PHASE NOISE, GYROSCOPE COMPRISING SAID MEMS OSCILLATOR AND METHOD FOR OPERATING SAID MEMS OSCILLATOR**

(30) Priority: 30.04.2025 IT 202500009687
(71) Applicant: STMicroelectronics International N.V., 1228 Plan-les-Ouates, Geneva (CH)
(72) Inventor: FURCERI, Raffaele Enrico, 20864 Agrate Brianza (MB) (IT); ZAMPROGNO, Marco, 20864 Agrate Brianza (MB) (IT); FLORA, Pasquale, 20864 Agrate Brianza (MB) (IT); BARBIERI, Andrea, 20864 Agrate Brianza (MB) (IT)
(74) Representative: Studio Torta S.p.A.

(57) **Abstract**

A MEMS oscillator (11) includes: an oscillating MEMS structure (12, 12a); and a sustaining circuit (13), configured to sustain oscillations of the MEMS structure (12, 12a) at a drive frequency (f_{D}). The sustaining circuit (13) comprises a comparator (15) coupled to the MEMS structure (12, 12a) to receive a read signal (+ΔV_{R}, -ΔV_{R}) indicative of the oscillations of the MEMS structure (12, 12a) and configured to provide a comparison signal (V_{COMP}) as a function of the read signal (+ΔV_{R}, -ΔV_{R}). The comparator (15) comprises: a sign sense stage (32), configured to provide a raw comparison signal (V_{CR}) as a function of the read signal (+ΔV_{R}, -ΔV_{R}); a switching stage (31), configured to alternate a polarity of the read signal (+ΔV_{R}, -ΔV_{R}) at the input of the sign sense stage (32) based on a control signal (V_{CTRL}) having a switching frequency (f_{COMM}) lower than the drive frequency (f_{D}); and a selection stage (33), configured to select one of the raw comparison signal (V_{CR}) and a negated raw comparison signal (V_{CRN}) based on the control signal (V_{CTRL}) and to assign a corresponding selected value to the comparison signal (V_{COMP}).

## Description

### Technical Field

The present invention relates to a microelectromechanical (MEMS) oscillator with reduced phase noise, and in particular to a gyroscope comprising said MEMS oscillator, and to a method for operating said MEMS oscillator.

### Background

MEMS oscillators are primarily used in timing reference systems, such as for example precision watches and highfrequency clocks, or as subsystems within sensors, such as for example gyroscopes, magnetometers, micromirrors and frequency-modulated accelerometers.

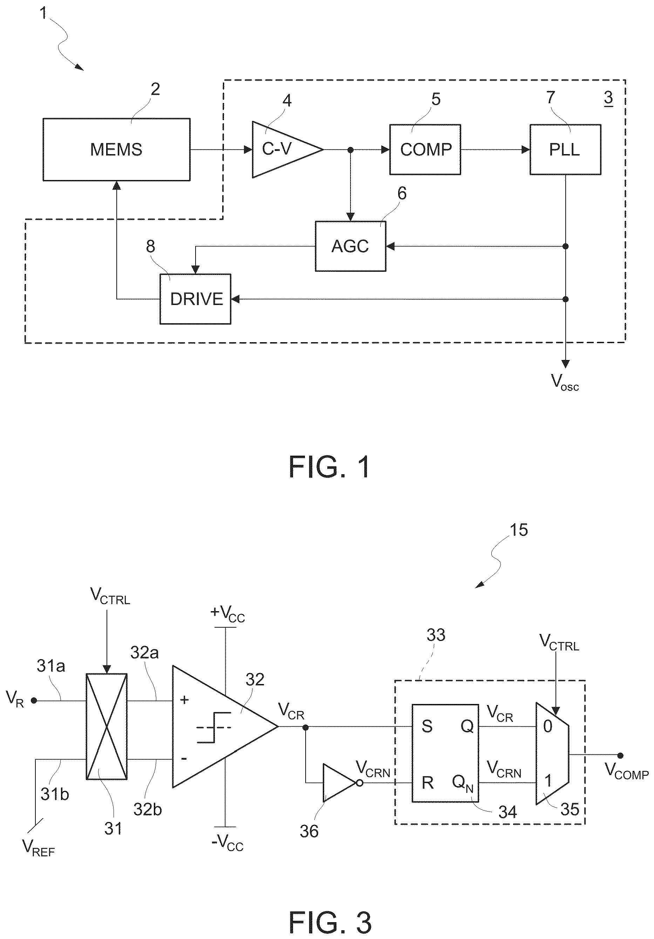

With reference to Figure 1, a MEMS oscillator 1 typically comprises a MEMS structure (also referred to as a "resonator") 2, having a natural resonance frequency, and a sustaining circuit 3, the latter being configured to keep the MEMS structure 2 in oscillation around a predefined working point by providing a forcing. The sustaining circuit 3 defines, together with the MEMS structure 2, an oscillation loop of the oscillator 1. In particular, the MEMS structure 2 functions as a frequency-selective element of this oscillation loop, while the sustaining circuit 3 comprises elements that allow the Barkhausen's stability criterion to be met, i.e. to keep the oscillation stable. More in particular, the sustaining circuit 3 comprises: a read stage 4, that provides a read signal indicative of the oscillations of the MEMS structure 2 (for example, a charge-to-voltage converter); an oscillation amplitude control stage, such as, for example, an Automatic Gain Control (AGC) circuit 6; and oscillation phase control stages, such as, for example, a comparator 5 and a Phase-Locked Loop (PLL) 7. Even more in particular, the automatic gain control circuit 6 receives at input the read signal from the read stage 4, processing it using an output of the phase-locked loop 7 (i.e., for example, by means of a coherent demodulation). A forcing stage 8, that receives at input both an output of the automatic gain control circuit 6 and an output of the phase-locked loop 7, then closes the oscillation loop, providing the suitable voltages to the drive terminals of the MEMS structure 2 to actuate the oscillations.

In practice, non-idealities of components of the amplitude and phase control stages have an impact on the characteristics of the oscillation produced (V_{OSC}, in Figure 1) by the MEMS oscillator. For example, an always increasing reduction in the size of the electronic components of the sustaining circuit and resulting manufacturing imperfections may produce unwanted effects, such as uncertainties in the operating thresholds, mismatches and more generally random phenomena, such that the oscillation at the output of the oscillator departs from the desired one.

The Applicant has verified that defects and uncertainties in the comparison threshold of a comparator of the sustaining circuit may produce variations, drifts and phase delays (more generally referred to as "phase shifts" or "phase noise") at the output of the oscillator. For example, the phase noise introduced by the comparator depends on the amount of the input offset that modifies the comparison threshold of the same comparator; more in particular, the phase shift introduced by the comparator is approximately proportional to the input offset. This implies that the lower the amplitude of an input signal to the comparator, the greater the phase delay induced by the same comparator. The phase shifts introduced by the comparator may effectively alter the time characteristics (for example, the duty cycle) of the oscillating signal at the output of the comparator. Furthermore, the input offset of the comparator may undergo variations during the life of the oscillator, for example due to environmental and/or thermomechanical stress conditions to which the oscillator is subject.

When the oscillator is part of a sensor such as an amplitude-modulated (AM) gyroscope, for example a mode-matched type or mode-split type gyroscope, the phase noise introduced by the stages of the sustaining circuit may cause offsets in the reading of a sense signal of the gyroscope, especially in the presence of quadrature errors of the gyroscope. In fact, in such gyroscopes the sense signal is coherently demodulated using as a demodulation signal a same drive signal provided to the oscillating MEMS structure (and resulting from the oscillation loop): a phase shift between the sense signal and the demodulation signal brings a quadrature contribution to the gyroscope reading and causes a zero drift or ZRL ("Zero Rate Level") drift.

In addition, the measurement of a gyroscope affected by a zero drift may show variations in the offset level identifiable as jumps having a specific time profile, with relatively low frequency. This noisiness of the ZRL drift is associable with Random Telegraph Noise (RTN) events and may be traced back, ultimately, to the phase noise introduced by the oscillator, and more in particular by the comparator. A need is therefore felt, in gyroscopes, to eliminate phase errors in the demodulation of the sense signal, in order to reduce as much as possible read contributions due to quadrature errors.

Solutions that envisage the use of electronic components having increased size, or that envisage an increase in the oscillation amplitude or that, in gyroscopes, use additional electrodes for reducing the quadrature error, may not be entirely satisfactory in terms of phase noise reduction and/or may introduce correlated disadvantages such as an increase in the occupation area and in integrated circuit consumptions and complexity (or even impossibility) of correcting the phase shifts during the life of the oscillator.

### Summary

It is therefore an aim of the present invention to overcome or at least partially mitigate the disadvantages and limitations of the state of the art.

According to the present invention, a MEMS oscillator, a gyroscope comprising said MEMS oscillator, and a method for operating said MEMS oscillator are presented as defined in the attached claims.

### Brief Description of the Figures

For a better understanding of the present invention, preferred embodiments are presented, by way of non-limiting example, with reference to the attached drawings, wherein:
- Figure 1 is a simplified block diagram of a MEMS oscillator according to the state of the art;
- Figure 2 is a simplified block diagram of a gyroscope comprising a MEMS oscillator in accordance with an embodiment of the present invention;
- Figure 3 is a simplified and principle block diagram of a comparator of the MEMS oscillator of Figure 2 in accordance with an embodiment of the present invention;
- Figures 4A and 4B are simplified block diagrams of a component of the comparator of Figure 3 in accordance with an embodiment of the present invention, in a first operating configuration and in a second operating configuration, respectively;
- Figure 5 shows time diagrams relating to the operation of the comparator of Figures 3, 4A and 4B;
- Figures 6A and 6B are simplified block diagrams of a component of the comparator of Figure 3 in accordance with a further embodiment of the present invention, in a first operating configuration and in a second operating configuration, respectively; and
- Figure 7 shows a time diagram relating to the operation of the comparator of Figures 3, 6A and 6B.

### Description of Embodiments

The following description refers to the arrangement shown in the drawings; accordingly, expressions such as "above", "below", "upper", "lower", "top", "bottom", "right", "left" and the like relate to the attached Figures and are not to be construed in a limiting manner.

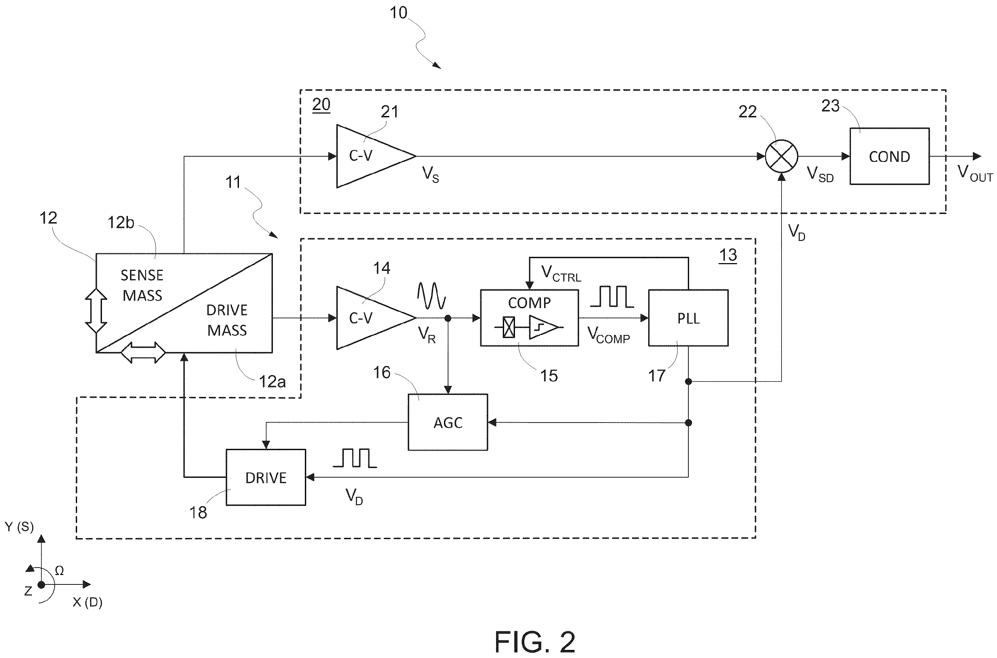

Figure 2 shows a MEMS gyroscope according to an embodiment of the present invention, indicated as a whole by the numeral 10 and comprising a MEMS structure 12, a sustaining circuit 13 and a processing circuit 20.

The MEMS structure 12 of the gyroscope 10 comprises a drive mass 12a, configured to oscillate in a controlled manner along a drive axis X, and a sense mass 12b, constrained to the drive mass 12a so as to be able to oscillate along a sense axis Y, perpendicular to the drive axis X, in response to a rotation around a rotation axis Z, perpendicular to the drive axis X and the sense axis Y, due to the Coriolis force. In the non-limiting embodiment of Figure 2, the drive axis X and the sense axis Y are both "in-plane" axes, while the rotation axis Z is an "out-of-plane" axis. Furthermore, again without limitation in relation to what is described below, the drive mass 12a and the sense mass 12b may be distinct masses of the MEMS structure 12 (two-movable-mass gyroscope), or they may be portions of a single movable mass of the MEMS structure 12 (single-movable mass gyroscope).

The sustaining circuit 13 of the gyroscope 10 is configured to keep the MEMS structure 12, and specifically the drive mass 12a, in oscillation around a predefined working point, at a drive frequency f_{D} along the drive axis X. The drive frequency f_{D} is for example substantially equal to a natural resonance frequency of a resonance mode of the MEMS structure 12 along the drive axis X. The sustaining circuit 13 and the drive mass 12a of the MEMS structure 12 therefore form a MEMS oscillator 11, entirely similar to that introduced with reference to Figure 1. In particular, the sustaining circuit 13 defines, together with the drive mass 12a of the MEMS structure 12, an oscillation loop of the oscillator 11, wherein the drive mass 12a functions as a frequency-selective element, while the sustaining circuit 13 comprises elements that allow the Barkhausen's stability criterion to be met, i.e. to keep the drive oscillation of the gyroscope 10 stable.

In detail, the sustaining circuit 13 comprises: a read stage 14, providing at output a read signal V_{R} indicative of the drive oscillations of the drive mass 12a, for example a charge-to-voltage converter; a comparator 15, configured to receive at input the read signal V_{R} and to provide at output a comparison signal V_{COMP}; a gain stage 16, for example an Automatic Gain Control (AGC) circuit; a Phase-Locked Loop (PLL) 17, configured to receive at input the comparison signal V_{COMP}; and a forcing stage 18. The gain stage 16 controls the amplitude of the drive oscillations; the comparator 15 and the phase-locked loop 17 generally form a phase-control stage for the drive oscillations, that also allows to provide a synchronization signal useful for those operations of the gyroscope 10 that require a specific time base, as described in more detail below. Finally, the forcing stage 18 closes the oscillation loop, by providing drive terminals of drive mass 12a with voltages suitable for actuating the drive oscillations, based on a drive signal V_{D} (at the drive frequency f_{D}) of the oscillation loop of the oscillator 11. For example, such drive terminals are internally connected to mutually coupled fixed and movable driving electrodes, for capacitive actuation of the drive mass 12a.

As anticipated, the sense mass 12b of the MEMS structure 12 oscillates along the sense axis Y at a sense frequency f_{S} in response to a rotation of the gyroscope 10 around the rotation axis Z. For example, in a non-limiting embodiment of a "mode-matched" type gyroscope, the sense frequency f_{S} is a natural resonance frequency of a resonance mode of the MEMS structure 12 along the sense axis Y. More generally, the gyroscope 10 is an Amplitude-Modulated (AM) gyroscope; for example, the gyroscope 10 may also be a "mode-split" type gyroscope.

The processing circuit 20 comprises in detail a sense stage 21, a multiplier 22 and a conditioning stage 23. The sense stage 21, for example a charge-to-voltage converter, reads a capacitive variation between movable sensing electrodes and fixed sensing electrodes of the sense mass 12b, providing a sense signal V_{S} indicative of the movement of the sense mass 12b along the sense axis Y.

The multiplier 22 and the conditioning stage 23 implement a coherent demodulation of the sense signal V_{S}, using as a demodulation signal the drive signal V_{D} resulting from the same oscillation loop of the oscillator 11, and in particular generated by the phase-locked loop 17, as described in more detail below. In detail, the multiplier 22 receives at a first input the sense signal V_{S} and at a second input the drive signal V_{D}, and provides at output a demodulated signal V_{SD}. A low-pass filter of the conditioning stage 23 then returns a baseband component of the demodulated signal V_{SD}; in particular, the low-pass filter of the conditioning stage 23 has cutoff and slope characteristics such as to substantially preserve the sole baseband component of the signal at its input, thus eliminating intermodulation products and any unwanted noise components. The conditioning stage 23 may also comprise further processing stages of the demodulated signal V_{SD}, such as further filters and gain stages, providing an output signal V_{OUT} intended for a digital processing chain of the gyroscope 10 (not shown in the attached Figures) for the calculation of an angular velocity.

In a non-limiting embodiment, the sustaining circuit 13 and the processing circuit 20 are implemented for example by an ASIC (Application Specific Integrated Circuit).

According to one aspect of the present invention, the comparator 15 of the gyroscope 10 implements a "chopper" modulation function of the read signal V_{R}, in order to reduce the phase noise of the sustaining circuit 13 of the oscillator 11 and, ultimately, the presence of offsets (ZRL drifts) with RTN noise in the demodulated signal V_{SD}.

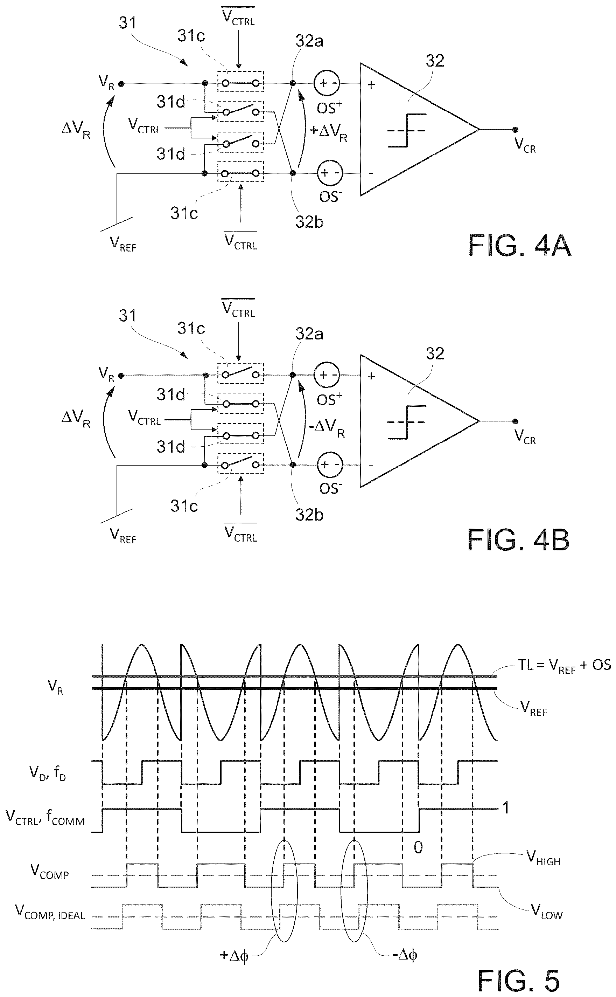

With reference also to Figure 3, Figure 4A and Figure 4B, the comparator 15 comprises: a switching stage 31, a sign sense stage 32 and a selection stage 33 connected in cascade. In detail, the switching stage 31 receives at input the read signal V_{R} from the read stage 14 of the sustaining circuit 13 and the selection stage 33 provides at output to the phase-locked loop 17 the comparison signal V_{COMP}.

The switching stage 31 has a first input terminal 31a and a second input terminal 31b between which a differential read signal ΔV_{R} is present. In a non-limiting embodiment, for example, the first input terminal 31a receives the read signal V_{R} and the second input terminal 31b receives a comparison threshold V_{REF}; in this case the differential read signal ΔV_{R} is given by the difference ΔV_{R} = V_{R}-V_{REF}. The switching stage 31 also has a first output terminal and a second output terminal respectively connected to a first input terminal 32a and a second input terminal 32b of the sign sense stage 32. The switching stage 31 also has a first state, wherein the first input terminal 31a and the second input terminal 31b are connected to the first output terminal and the second output terminal, respectively; and a second state, wherein the first input terminal 31a and the second input terminal 31b are connected to the second output terminal and the first output terminal, respectively. The switching stage 31 is configured to switch between the first state and the second state as a function of a control signal V_{CTRL}. The control signal V_{CTRL} is for example a square wave signal that may assume a high logic value (e.g., 1) and a low logic value (e.g., 0), as shown in Figure 5, and has a switching frequency f_{COMM} equal to a fraction f_{D}/N of the drive frequency f_{D}, where N is an integer at least equal to 2. The control stage 31 is then configured to alternate the polarity of the read signal at the input of the sign sense stage 32 based on the control signal V_{CTRL} and thus implements a "chopper" modulation. More precisely, the sign sense stage 32 receives a direct read signal +ΔV_{R} equal to the differential read signal ΔV_{R}, when the control signal V_{CTRL} has the low logic value and the switching stage 31 is in the first state; and an inverted read signal -ΔV_{R} that is equal and has a sign opposite to the differential read signal ΔV_{R}, when the control signal V_{CTRL} has the high logic value and the switching stage 31 is in the second state. The read signal at the input of the sign sense stage 32 switches between the direct read signal +ΔV_{R} and the inverted read signal -ΔV_{R} when the control signal V_{CTRL} switches.

In a non-limiting embodiment, the switching stage 31 is configured to apply, based on the control signal V_{CTRL}, the read signal V_{R} to one of the first input terminal 32a and the second input terminal 32b of the sign sense stage 32; and to apply a comparison reference voltage equal to the comparison threshold V_{REF} to the other of the first input terminal 32a and the second input terminal 32b of the sign sense stage 32.

The switching stage 31 is implemented, in an embodiment of the present invention, by the circuit shown in Figures 4A and 4B and comprises a plurality of switches operable based on the control signal V_{CTRL}. In more detail, the switching stage 31 comprises a first pair of switches 31c, closed when the control signal V_{CTRL} assumes the low logic value (Figure 4A) and open when the control signal V_{CTRL} assumes the high logic value (Figure 4B), and a second pair of switches 31d, open when the control signal V_{CTRL} assumes the low logic value (Figure 4A) and closed when the control signal V_{CTRL} assumes the high logic value (Figure 4B). Each of the first input terminal 32a and the second input terminal 32b of the sign sense stage 32 is connected to a switch of the first pair of switches 31c and to a switch of the second pair of switches 31d. In the embodiment of Figures 3, 4A, and 4B, therefore, when the control signal V_{CTRL} has the low logic value (V_{CTRL}=0, Figure 4A), the switches of the first pair of switches 31c are closed and the sign sense stage 32 receives the direct read signal +ΔV_{R} (e.g., the read signal V_{R} is applied to a non-inverting terminal of the sign sense stage 32, while the comparison reference voltage V_{REF} is applied to an inverting terminal thereof); when instead the control signal V_{CTRL} has the high logic value (V_{CTRL}=1, Figure 4B), the switches of the second pair of switches 31d are closed and the sign sense stage 32 receives the inverted read signal -ΔV_{R} (e.g., the read signal V_{R} is applied to the inverting terminal of the sign sense stage 32, while the comparison reference voltage V_{REF} is applied to the non-inverting terminal thereof). For example, the switches of the first and second pair of switches 31c, 31d are made by using CMOS technology.

The sign sense stage 32 is configured to return a low limit value V_{LOW} or a high limit value V_{HIGH} as a function of the value assumed by the read signal V_{R} with respect to a comparison threshold (or, toggling level) V_{REF} and a state of the switching stage 31; in other words, the sign sense stage 32 implements the comparison function proper of the comparator 15. In detail, the sign sense stage 32 provides at output to the selection stage 33 a raw comparison signal V_{CR}, that may alternatively assume the low limit value V_{LOW} or the high limit value V_{HIGH} as a function of the value of the differential read signal ΔV_{R}. The sign sense stage 32 therefore transforms the read signal V_{R}, for example with a sinusoidal trend, into the raw comparison signal V_{CR}, i.e. into a signal with a square wave trend that switches between the low limit value V_{LOW} and the high limit value V_{HIGH} at the drive frequency f_{D}. In a non-limiting embodiment, the sign sense stage 32 is implemented for example by an operational amplifier in a comparison configuration, and may internally comprise one or more stages. In more detail, the first input terminal 32a and the second input terminal 32b of the sign sense stage 32 are, for example, a non-inverting terminal and an inverting terminal, respectively. The low limit value V_{LOW} and the high limit value V_{HIGH} may for example be values of respective supply voltages +V_{CC}, -V_{CC} of the operational amplifier; for example, the low limit value V_{LOW} and the high limit value V_{HIGH} may be opposite to each other, or one may have a positive (or negative) value and the other a value equal to 0V. Again, in a non-limiting manner, the comparison threshold V_{REF} is for example equal to 0V.

The selection stage 33 is configured to set the comparison signal V_{COMP} at an output of the comparator 15 to the low limit value V_{LOW} or the high limit value V_{HIGH} as a function of the value of the differential read signal ΔV_{R}, regardless of the variations in the control signal V_{CTRL}, i.e., regardless of the change in polarity at the input of the sign sense stage 32. Specifically, the selection stage 33 selects one of the raw comparison signal V_{CR} and a negated raw comparison signal V_{CRN} and assigns the corresponding value to the comparison signal V_{COMP}. In practice, the raw comparison signal V_{CR} is inverted at the output of the sign sense stage 32 as a function of the control signal V_{CTRL} as the switching stage 31 alternates the polarity of the read signal +ΔV_{R}, -ΔV_{R} at the inputs of the same sign sense stage 32, so that the value of the comparison signal V_{COMP} is determined by the differential read signal ΔV_{R}, but not by the same control signal V_{CTRL} (except as to the phase delay, as explained below). When the switching stage 31 provides the direct read signal +ΔV_{R} to the sign sense stage 32 (i.e., when V_{CTRL}=0), the selection stage 33 assigns the value of the raw comparison signal V_{CR} to the comparison signal V_{COMP}; when the switching stage 31 provides the inverted read signal -ΔV_{R} to the sign sense stage 32 (i.e., when V_{CTRL}=1), the selection stage 33 assigns the value of the negated raw comparison signal V_{CRN} to the comparison signal V_{COMP}.

In detail, the selection stage 33 comprises a memory element 34 followed by a decision element 35, the latter being controlled by the control signal V_{CTRL}.

The memory element 34 has two outputs, at which the raw comparison signal V_{CR} and the negated raw comparison signal V_{CRN}, respectively, are present. In an embodiment, for example, the memory element 34 is an SR (Set-Reset) bistable or latch and has a set input S and a reset input R that receive the raw comparison signal V_{CR} and the negated raw comparison signal V_{CRN}, respectively (as represented by the inverting element 36). Consequently, the direct output Q provides the raw comparison signal V_{CR} and the negated output Q_{N} provides the negated raw comparison signal V_{CRN}.

The decision element 35, that in the non-limiting embodiment of Figure 3 comprises for example a multiplexer, selects the direct output Q of the SR latch when the control signal V_{CTRL} has the low logic value (V_{CTRL}=0, i.e. when the sign sense stage 32 receives the direct read signal +ΔV_{R}), while it selects the negated output Q_{N} when the control signal V_{CTRL} has the high logic value (V_{CTRL}=1, i.e. when the sign sense stage 32 receives the inverted read signal -ΔV_{R}).

In practice, the sign sense stage 32 is subject to non-idealities such as for example input offsets. Again, with reference to Figures 4A and 4B, the sign sense stage 32 is represented taking into account an input offset for the non-inverting terminal 32a, OS⁺, and an input offset for the inverting terminal 32b, OS⁻.

The switching stage 31 of the comparator 15 of the present invention operates, therefore, a dynamic switching of the input offset of the sign sense stage 32 as seen by the read signal V_{R}, based on the control signal V_{CTRL}. In this manner, the sign sense stage 32 provides at output the low limit value V_{LOW} or the high limit value V_{HIGH} alternatively undergoing the effect of the input offset OS⁺ or the input offset OS⁻, depending on the logic value of the control signal V_{CTRL}. The chopper modulation provided by the switching stage 31 is therefore a modulation of the input offset of the comparator 15 and, ultimately, of the phase variation (i.e., of the delay or advance) introduced by the same comparator 15, as described in more detail below.

As already mentioned, according to a further aspect of the present invention, the switching frequency f_{COMM} of the control signal V_{CTRL} is no more than half the drive frequency f_{D} of the drive oscillations of the MEMS structure 12. In a non-limiting embodiment, the switching frequency f_{COMM} of the control signal V_{CTRL} is for example equal to half the drive frequency f_{D}. In such a situation, the polarity of the signal at the input of the sign sense stage 32 switches at each cycle of the drive signal V_{D}. In practice, at each cycle of the control signal V_{CTRL}, the comparison stage 32 receives the direct read signal +ΔV_{R} in a first half-cycle and the inverted read signal -ΔV_{R} in a second half-cycle.

As indicated in Figure 2, in a non-limiting embodiment, the control signal V_{CTRL} is generated by the phase-locked loop 17, that synchronizes it with the drive signal V_{D}; for example, the phase-locked loop 17 internally comprises frequency divider stages to obtain the switching frequency f_{COMM} from the drive frequency f_{D}.

Figure 5 shows in detail: the read signal V_{R} at the input of the sign sense stage 32, wherein the polarity exchange is evident; the drive signal V_{D} at the drive frequency f_{D}, as it is output for example from the phase-locked loop 17; the control signal V_{CTRL} at the switching frequency f_{COMM} (e.g. with f_{COMM}=f_{D}/2); the actual comparison signal V_{COMP} at the output of the comparator 15; and an ideal comparison signal V_{COMP,IDEAL} that would be obtained if the comparator 15 (and, in particular, the sign sense stage 32) were not subject to input offsets. In particular, the comparison threshold V_{REF} in the ideal state, i.e. in the absence of an input offset, and an actual comparison threshold TL, that coincides with the comparison threshold V_{REF} modified by an average input offset OS of the comparator 15, are shown at the top of Figure 5. In detail, the comparison signal V_{COMP} changes its admissible level when the read signal V_{R} crosses the actual comparison threshold TL, while the ideal comparison signal V_{COMP,IDEAL} changes its admissible level when the read signal V_{R} crosses the comparison threshold V_{REF} (i.e. when the differential read signal ΔV_{R} is zero). As may be observed in the indicated regions, the comparison signal V_{COMP} is either in advance (-Δφ) or in delay (+Δφ), alternating, with respect to the ideal comparison signal V_{COMP,IDEAL}: the dynamic switching of the polarity at the input of the sign sense stage 32, i.e. the dynamic switching of the input offset, therefore determines, at the output of the comparator 15, an equivalent modulation of the phase variation introduced due to the presence of input offsets. In practice, in successive half-cycles of the control signal V_{CTRL} the phase advances and delays are inverted and, on average, the effect on the comparison signal V_{COMP} is substantially removed.

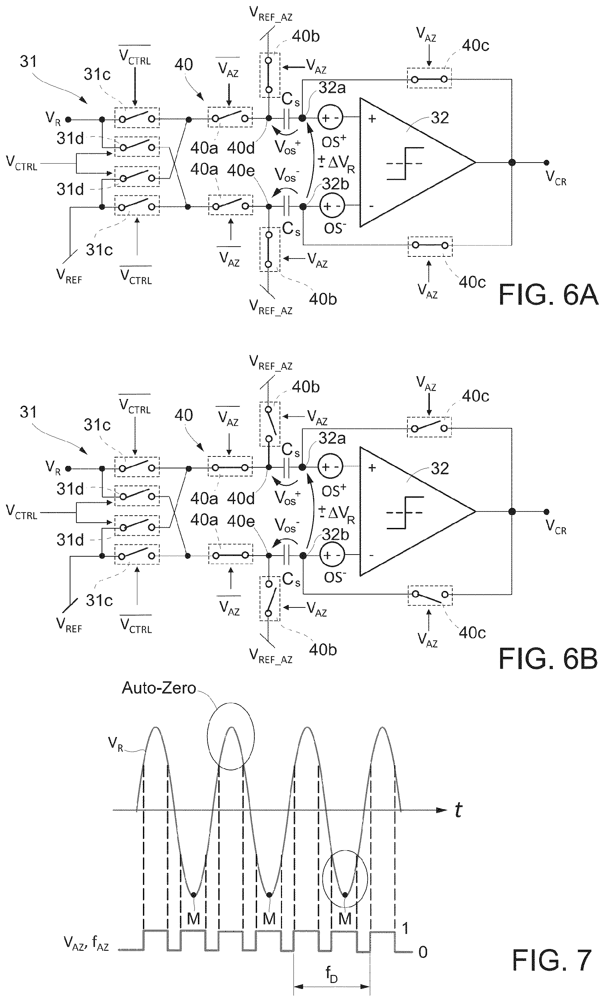

As also shown in Figure 7, the dynamic switching from the switching stage 31 is operated at a time instant sufficiently far from a toggling region, i.e. from crossing the effective comparison threshold TL, of the read signal V_{R}; for example, the dynamic switching is operated at peaks (maximum or minimum peaks) of the read signal V_{R}, for example in the time diagrams of Figure 5 and Figure 7, at minimums M of the read signal V_{R}.

The Applicant has verified that any zero drifts (for simplicity indicated below as ZRL offset) of the output signal V_{OUT} of the gyroscope 10 depend on the phase variations introduced by the components of the sustaining circuit 13, and in particular by the comparator 15, according to: $ZRL : = {V}_{OUT} \left(Ω=0\right) ∝ {A}_{Q} ⋅ sin \left(φ\left(t\right)\right)$ where, A_{Q} is a coefficient indicative of the quadrature contribution present in the sense signal V_{S} and φ(t) is the phase variation introduced by the dynamic switching described above and as shown in Figure 5.

Thanks to the chopper modulation, the fluctuations of the RTN type of the ZRL offset may then be shifted from the DC component to a precise frequency - i.e. the switching frequency f_{COMM} - and be successively filtered. For example, a filtering at the switching frequency f_{COMM} of the demodulated signal V_{SD} by the conditioning stage 23 allows to substantially reduce the RTN noise of the ZRL offset present on the sense signal V_{S}. Alternatively, such a filtering may be implemented by the digital processing chain of the gyroscope 10 successive to the conditioning stage 23.

Ultimately, the chopper modulation introduced by the switching stage 31 allows to obtain benefits in terms of phase noise on the signal used for the demodulation of the sense signal V_{S} of the gyroscope 10, and therefore in terms of fluctuations of any ZRL offsets present. Furthermore, by making the demodulation of the sense signal V_{S} more stable over time, the read contributions due to quadrature errors are significantly reduced, without increasing the complexity of the system.

With reference now to both Figures 6A, 6B and Figure 7, a variant of the comparator 15 is described with respect to what has been shown in Figures 3, 4A and 4B. In detail, the comparator 15 of Figures 6A, 6B comprises, in addition to the switching stage 31, an auto-zero stage 40 of the sign sense stage 32, downstream of the switching stage 31. In more detail, the auto-zero stage 40 is configured to sample (in a first step) and cancel (in a second step) the input offsets OS⁺, OS⁻ of the sign sense stage 32, based on an auto-zero signal V_{AZ}.

The auto-zero stage 40 comprises in detail first auto-zero switches 40a, second auto-zero switches 40b and third auto-zero switches 40c. Furthermore, the auto-zero stage 40 comprises two auto-zero capacitors C_{S} in series with the first input terminal 32a and the second input terminal 32b of the sign sense stage 32, respectively. More precisely, the auto-zero capacitors C_{S} are connected the one between a first auto-zero node 40d and the first input terminal 32a of the sign sense stage 32 and the other between a second auto-zero node 40e and the second input terminal 32b of the sign sense stage 32.

The first auto-zero switches 40a are controlled by a negated auto-zero signal V_{AZN} and are connected to selectively couple and decouple each output of the switching stage 31 to a respective one of the first auto-zero node 40d and the second auto-zero node 40e. The second auto-zero switches 40b are controlled by the auto-zero signal V_{AZ} and are connected to selectively couple and decouple the first auto-zero node 40d and the second auto-zero node 40e to a reference voltage source (not shown), providing an auto-zero reference voltage V_{REF_AZ}. Finally, the third auto-zero switches 40c are controlled by the auto-zero signal V_{AZ} and are connected to selectively couple and decouple the first input terminal 32a and the second input terminal 32b to the output of the sign sense stage 32. For example, the first auto-zero switches 40a, the second auto-zero switches 40b, and the third auto-zero switches 40c are made by using CMOS technology.

In an offset sampling step (Figure 6A), the first auto-zero switches 40a are open (i.e., in the diagram of Figure 6A, when the auto-zero signal V_{AZ} assumes a high logic value, e.g. 1, and the negated auto-zero signal V_{AZN} assumes a low logic value, e.g. 0), while the second auto-zero switches 40b and the third auto-zero switches 40c are closed. In this configuration, the input offsets OS⁺, OS⁻ of the sign sense stage 32 are stored on the respective auto-zero capacitors C_{S} that charge at respective offset cancellation voltages V_{OS}⁺, V_{OS}⁻. In a successive offset cancellation step (Figure 6B), the second auto-zero switches 40b and the third auto-zero switches 40c are open, while the first auto-zero switches 40a are closed. The sign sense stage 32 receives the differential read signal ΔV_{R} from the switching stage 31 and the offset cancellation voltage V_{OS} present on the auto-zero capacitors C_{S} approximately compensates the input offsets OS⁺, OS⁻.

By means of the diagram of Figures 6A and 6B, therefore, the chopper modulation of the switching stage 31 previously described may operate on already significantly reduced input offset levels, i.e. on residual input offsets. The auto-zero stage 40 in fact allows to reduce the impact of the chopper modulation on the spectrum of the signals generated by the phase-locked loop 17, in terms of spurious harmonics introduced, especially in the presence of relatively high input offsets.

To avoid disturbances to the sign sense stage 32, the auto-zero functionality of the sampler 15 is also operated in a portion of the cycle of the drive signal V_{D} (and therefore of the read signal V_{R}) sufficiently far from the toggling region. As shown in Figure 7, the auto-zero procedure may be performed in each half-cycle of the read signal V_{R} (two indicated in Figure 7), for example in proximity of each peak (that is maximum or minimum). In detail, an auto-zero frequency f_{AZ} of the auto-zero signal V_{AZ} is greater than or equal to the drive frequency f_{D}; in a non-limiting embodiment, the auto-zero frequency f_{AZ} is for example equal to twice the drive frequency f_{D}. Furthermore, the auto-zero signal V_{AZ} may also be generated by the phase-locked loop 17 that synchronizes it with the drive signal V_{D}; for example, the phase-locked loop 17 comprises internally frequency-multiplying stages to obtain the auto-zero frequency f_{AZ} from the drive frequency f_{D}.

It is understood that a comparator having chopping, and in addition auto-zero, functionality within a sustaining circuit according to the present invention may be applied to a generic oscillator (such as for example that shown in Figure 1). For example, the oscillator described above may be part of MEMS sensors or actuators other than gyroscopes (e.g., magnetometers, micromirrors, frequency-modulated sensors), or it may be part of a timing device or system configured to produce a timing output (e.g., a clock) at the drive frequency. For this reason, the description and representations relating to the gyroscope of the present invention are purely exemplary.

Finally, it is clear that modifications and variations may be made to what has been described and illustrated herein without thereby departing from the scope of the present invention, as defined in the attached claims.

For example, the sustaining circuit may additionally comprise a passive band-pass filter (for example, an RC filter) interposed between the read stage and the comparator. This allows to reduce the presence of any offsets (and highfrequency noises) of the read signal that might compromise the performance of the oscillation loop.

It is understood that the representation of the comparator of Figure 3 is only a principle diagram. For example, a different convention of the terminals of the sign sense stage may be used in manners equivalent to what has been described and shown, obtaining the same results presented (for example, a bipolar convention of the signals); or, circuit elements different from those shown may be used, while performing the same respective functions.

The auto-zero stage may be controlled by two auto-zero signals different from the auto-zero signal (and its negation) previously described. For example, the auto-zero stage may be controlled by means of two distinct auto-zero signals - one auto-zero signal that controls the second and third auto-zero switches, and another auto-zero signal that controls the first auto-zero switches - the auto-zero signals switching at different, predetermined time instants in order to avoid spurious openings and closings of the auto-zero switches and possible resulting unwanted discharges of the auto-zero capacitors.

## Claims

1. A MEMS oscillator (11) comprising:
- an oscillating MEMS structure (12, 12a); and
- a sustaining circuit (13), configured to sustain oscillations of the MEMS structure (12, 12a) at a drive frequency (f_{D}),
wherein the sustaining circuit (13) comprises a comparator (15) coupled to the MEMS structure (12, 12a) to receive a read signal (+ΔV_{R}, -ΔV_{R}) indicative of the oscillations of the MEMS structure (12, 12a) and configured to provide a comparison signal (V_{COMP}) as a function of the read signal (+ΔV_{R}, -ΔV_{R}),
wherein the comparator (15) comprises:
- a sign sense stage (32), configured to provide a raw comparison signal (V_{CR}) as a function of the read signal (+ΔV_{R}, -ΔV_{R});
- a switching stage (31), upstream of the sign sense stage (32), configured to alternate a polarity of the read signal (+ΔV_{R}, -ΔV_{R}) at the input of the sign sense stage (32) based on a control signal (V_{CTRL}) having a switching frequency (f_{COMM}) lower than the drive frequency (f_{D}); and
- a selection stage (33), downstream of the sign sense stage (32), configured to select one of the raw comparison signal (V_{CR}) and a negated raw comparison signal (V_{CRN}) based on the control signal (V_{CTRL}) and to assign a corresponding selected value to the comparison signal (V_{COMP}).

2. The oscillator (11) according to claim 1, wherein the selection stage (33) is configured to assign the value of the raw comparison signal (V_{CR}) to the comparison signal (V_{COMP}) when the switching stage (31) provides the read signal (+ΔV_{R}, -ΔV_{R}) with a first polarity (+ΔV_{R}) to the sign sense stage (32), and to assign the value of the negated raw comparison signal (V_{CRN}) to the comparison signal (V_{COMP}) when the switching stage (31) provides the read signal (+ΔV_{R}, - ΔV_{R}) with a second polarity (-ΔV_{R}) to the sign sense stage (32) .

3. The oscillator (11) according to claim 1 or 2, wherein the selection stage (33) comprises:
- a memory element (34), coupled to the sign sense stage (32) to receive the raw comparison signal (V_{CR}) and having a first output (Q), providing the raw comparison signal (V_{CR}), and a second output (Q_{N}), providing the negated raw comparison signal (V_{CRN}); and
- a decision element (35), controlled by the control signal (V_{CTRL}) and configured to select one of the raw comparison signal (V_{CR}) and the negated raw comparison signal (V_{CRN}).

4. The oscillator (11) according to the preceding claim, wherein the memory element (34) comprises a bistable, having a first input (S) receiving the raw comparison signal (V_{CR}) and a second input (R) receiving the negated raw comparison signal (V_{CRN}), and wherein the decision element (35) comprises a multiplexer controlled by the control signal (V_{CTRL}).

5. The oscillator (11) according to any of the preceding claims, wherein the raw comparison signal (V_{CR}) alternatively assumes a low limit value (V_{LOW}) or a high limit value (V_{HIGH}) as a function of the value of the read signal (+ΔV_{R}, -ΔV_{R}).

6. The oscillator (11) according to any of the preceding claims, wherein the switching stage (31) comprises switches (31c, 31d) operable based on the control signal (V_{CTRL}), the switching stage (31) implementing a chopper modulation of the read signal (+ΔV_{R}, -ΔV_{R}).

7. The oscillator (11) according to the preceding claim, wherein the switching stage (31) comprises a first pair of switches (31c), closed when the control signal (V_{CTRL}) assumes a low logic value, and a second pair of switches (31d), closed when the control signal (V_{CTRL}) assumes a high logic value.

8. The oscillator (11) according to any of the preceding claims, wherein the drive frequency (f_{D}) and the switching frequency (f_{COMM}) are in integer ratio (f_{D}/N), for example equal to two.

9. The oscillator (11) according to any of the preceding claims, wherein the comparator (15) further comprises an auto-zero stage (40) of the sign sense stage (32), downstream of the switching stage (31), configured to store input offsets (OS⁺, OS⁻) of the sign sense stage (32), in a first operating configuration, and to cancel the input offsets (OS⁺, OS⁻), in a second operating configuration, based on a further control signal (V_{AZ}).

10. The oscillator (11) according to the preceding claim, wherein the first operating configuration comprises decoupling the sign sense stage (32) from the switching stage (31) and storing the input offsets (OS⁺, OS⁻) on auto-zero capacitors (C_{S}), and wherein the second operating configuration comprises coupling the sign sense stage (32) to the switching stage (31) to receive the read signal (+ΔV_{R}, -ΔV_{R}).

11. The oscillator (11) according to claim 9 or 10, wherein an auto-zero frequency (f_{AZ}) of the further control signal (V_{AZ}) is greater than or equal to the drive frequency (f_{D}).

12. A MEMS gyroscope (10) comprising a MEMS oscillator (11) according to any of the preceding claims,
wherein the MEMS structure (12, 12a) comprises a drive mass (12a) oscillating at the drive frequency (f_{D}) along a first axis (X), and wherein the sustaining circuit (13) further comprises a phase-locked loop (17), for controlling the phase of the oscillations of the MEMS structure (12, 12a) along the first axis (X) and coupled to the comparator (15) to receive the comparison signal (V_{COMP}), and
wherein the MEMS structure (12, 12b) is further oscillating at a sense frequency (f_{S}) along a second axis (Y), perpendicular to the first axis (X), in response to a rotation around a rotation axis (Z) perpendicular to the first axis (X) and the second axis (Y), the sense frequency (f_{S}) being substantially equal to the drive frequency (f_{D}).

13. The gyroscope (10) according to the preceding claim, wherein an output (V_{D}) of the phase-locked loop (17) is used for a coherent demodulation of a sense signal (V_{S}) of the gyroscope (10) indicative of oscillations of the MEMS structure (12, 12b) along the second axis (Y).

14. A method for operating a MEMS oscillator (11) comprising a MEMS structure (12, 12a), the method comprising:
- causing the MEMS structure (12, 12a) to oscillate at a drive frequency (f_{D});
- acquiring a read signal (+ΔV_{R}, -ΔV_{R}) indicative of the oscillations of the MEMS structure (12, 12a);
- providing the read signal (+ΔV_{R}, -ΔV_{R}) to a comparator (15), configured to return a comparison signal (V_{COMP}) as a function of the read signal (+ΔV_{R}, -ΔV_{R});
- obtaining a raw comparison signal (V_{CR}) as a function of the read signal (+ΔV_{R}, -ΔV_{R});
- assigning to the comparison signal (V_{COMP}) a corresponding value selected between the raw comparison signal (V_{CR}) and a negated raw comparison signal (V_{CRN}); and
- using the comparison signal (V_{COMP}) to sustain the oscillations of the MEMS structure (12, 12a),
wherein providing the read signal (+ΔV_{R}, -ΔV_{R}) to the comparator (15) comprises alternating a polarity of the read signal (+ΔV_{R}, -ΔV_{R}) at the input of the comparator (15) based on a control signal (V_{CTRL}) having a switching frequency (f_{COMM}) lower than the drive frequency (f_{D}), and
wherein the said corresponding value is selected based on the control signal (V_{CTRL}).

15. The method according to claim 14, wherein the value of the raw comparison signal (V_{CR}) is assigned to the comparison signal (V_{COMP}) when the read signal (+ΔV_{R}, -ΔV_{R}) is provided with a first polarity (+ΔV_{R}), and wherein the value of the negated raw comparison signal (V_{CRN}) is assigned to the comparison signal (V_{COMP}) when the read signal (+ΔV_{R}, - ΔV_{R}) is provided with a second polarity (-ΔV_{R}), and
wherein the drive frequency (f_{D}) and the switching frequency (f_{COMM}) are in an integer ratio (f_{D}/N), for example equal to two.
